# FASCICULE DE BREVET EUROPEEN

(11) **EP 3 343 604 B1**
(45) Date de publication et mention de la délivrance du brevet: **26.02.2025**
(21) Numéro de dépôt: 17204848.0
(22) Date de dépôt: 01.12.2017
(51) Int. Cl.: H01L 23/31, H01L 23/00, H05K 3/46, H01L 23/552, H05K 1/03, H05K 3/28, H01L 23/498

(54) **MODULES ELECTRONIQUES HERMETIQUES**
HERMETISCHE ELEKTRONISCHE MODULE
HERMETIC ELECTRONIC MODULES

(30) Priorité: 27.12.2016 FR 1663418
(43) Date de publication de la demande: 04.07.2018
(73) Titulaire: Packaging SIP, 78470 Saint-Rémy-lès-Chevreuse (FR)
(72) Inventeur: VAL, Christian, 78470 Saint-Rémy-lès-Chevreuse (FR); VAL, Alexandre, 78150 Le Chesnay (FR)
(74) Mandataire: Atout PI Laplace

(56) Documents cités:
- US-A- 5 355 016
- US-A1- 2010 213 621
- US-A1- 2013 248 828
- US-A1- 2014 327 150
- US-B1- 6 548 912

## Description

Le domaine de l'invention est celui de la fabrication collective de modules électroniques hermétiques.

Un module électronique comprend un ou plusieurs composants électroniques associés à un circuit d'interconnexion PCB (acronyme de l'expression anglo-saxonne Printed Circuit Board) multicouche qui comporte lui-même des plots destinés à recevoir des billes de brasure pour la connexion électrique externe du module électronique.

Ces composants peuvent être intégrés dans le PCB en étant placés sur une couche interne du PCB et on parle alors de PCB avec « Embedded Die » ou PCB à composant intégré. Ils peuvent aussi être encapsulés dans une résine de type époxy après avoir été collés et câblés au circuit PCB multicouche sur la face opposée à celle qui comporte les billes de brasure ; on parle alors de boîtiers à billes.

Les composants électroniques peuvent être des composants actifs tels que des puces et /ou des composants passifs tels que condensateurs, des inductances, etc, et/ou des MEMS acronyme de l'expression anglo-saxonne Micro Electro Mechanical System.

Le module électronique obtenu peut être autonome ou être lui-même reporté ainsi que d'autres modules électroniques sur un circuit imprimé comportant des plots électriquement conducteurs et une étape de refusion des billes du circuit PCB du module est réalisée pour connecter ces billes aux plots du circuit imprimé.

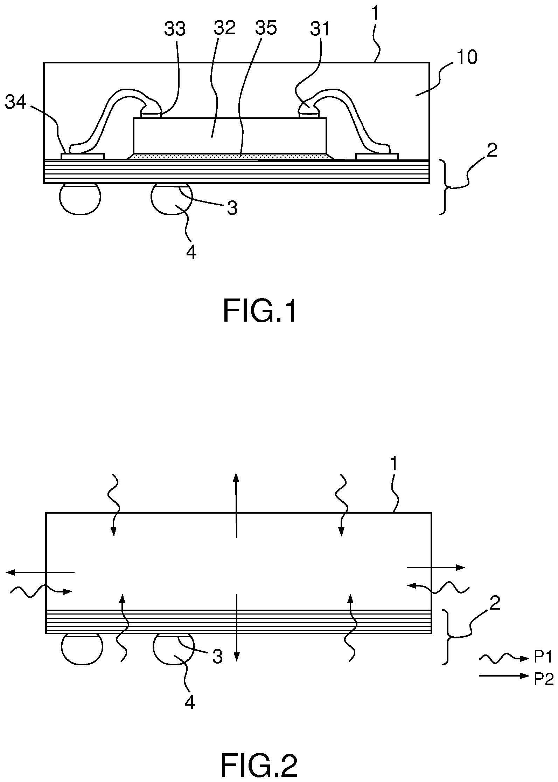

La figure 1 présente une coupe d'un boîtier 1 à billes (Ball Grid Array - BGA) destiné à être reporté sur un circuit imprimé ; seules deux billes 4 ont été représentées réalisées sur les plots 3 du circuit PCB 2. Le composant électronique 32 en l'occurrence une puce, est assemblé au circuit PCB 2 par un joint de colle ou une préforme 35. L'interconnexion électrique entre la puce et le circuit PCB est effectuée par des fils 31 qui sont soudés sur les plots 33 de la puce et les plots 34 du circuit PCB. La puce 32 et ses connexions 31 sont moulées dans une résine 10.

Il est connu que la résine dans laquelle sont moulés les composants électroniques, est étanche au liquide mais non-hermétique au gaz car aucun matériau organique n'est hermétique. Cela signifie, que l'humidité (gaz) diffusera à l'intérieur de celle-ci avec les conséquences bien connues des utilisateurs de boîtiers plastiques dans le monde :
- La pénétration de l'humidité à l'intérieur du boîtier avant le report en surface sur le circuit imprimé, génère une pression de vapeur interne dans ce boîtier pendant l'étape de refusion des billes qui s'effectue à une température maximale de 260 °C. Ce phénomène est illustré figure 2 où l'on peut voir un boîtier 1 à billes non hermétique (le composant n'est pas représenté pour ne pas surcharger la figure) qui, exposé à l'air ambiant reçoit par diffusion P1 le gaz H₂O. La pression résultante P2 va croître en quelques secondes de la pression atmosphérique à environ 2 fois celle-ci (273 + 260 /273 = 1, 95 Kg/cm2) ; cette pression crée des contraintes internes dont l'énergie se dissipe en créant des fissures internes dans le boîtier.
- La pénétration de la vapeur d'eau fait qu'en présence d'ions acides (CI, SO4, ...) ou basiques (Na, K, ....) il y a création d'acides ou de bases qui peuvent attaquer les parties métalliques des puces et notamment l'aluminium constituant les plots d'interconnexion, qui est un métal amphotère.

L'organisme de normalisation internationale JEDEC a donc déterminé plusieurs niveaux de qualité pour ces boîtiers uniquement sur le critère de la reprise d'humidité avant montage sur les circuits imprimés. Il y a 7 niveaux « Moisture Sensitive Level » dit MSL. Le niveau 6 a trait aux boîtiers les plus sensibles à l'humidité : après une durée de 6 heures avant report un tel boîtier sans emballage de protection doit de nouveau être dégazé. Le niveau 0 est le plus performant (→ le boîtier peut être stocké pendant une durée indéterminée), mais quasiment aucun boîtier plastique n'atteint cette performance.

Des travaux antérieurs, ont été conduits pour remédier au fait que les matériaux organiques sont intrinsèquement non-hermétiques. Ils sont basés sur le dépôt d'une couche anti diffusion d'un matériau non-organique et non électriquement conducteur afin d'éviter les courts-circuits.

Tous les matériaux non-organiques et non électriquement conducteurs comme les oxydes (Al₂O₃, ...), les nitrures (Si₃N₄, ...), les carbures etc, sont utilisables s'ils sont déposables à basse température (inférieure à 100 °C par exemple) et suffisamment déformables (ductiles) pour ne pas se fissurer après plusieurs cycles thermiques. On peut aussi citer l'oxyde de silicium (SiO₂) et plus précisément un oxyde non-stœchiométrique comme le SiOₓ avec x inférieur à 2. Cette couche minérale (= non organique) peut être déposée par « dépôt par plasma en phase vapeur » (PE-CVD Plasma Enhanced Chemical Vapor Deposition) mais en général les températures peuvent atteindre 200 °C ce qui est trop élevé pour des boîtiers plastiques. Fort heureusement, une technique dite de Plasma atmosphérique permet d'effectuer ces dépôts au-dessous de 100 °C ce qui devient acceptable pour ce type de boîtiers.

Plusieurs brevets ont été déposés :
- « Procédé et dispositif d'encapsulation hermétique pour composants électroniques » déposé le 24/08/1990 sous le N° : 90 10631.
- « Procédé et dispositif de protection hermétique de circuit électronique » déposé le 25/10/1994.
- « Dispositif d'encapsulation hermétique de composant devant être protégé de toute contrainte » déposé le 09/11/2001 sous le N° : 01 14543.

US 2013/0248828 A1 décrit le préambule de la revendication 1 annexée. US 2010/0213621 A1 décrit un module électronique dont les six surfaces externes sont entièrement recouvertes d'une couche organique hermétique.

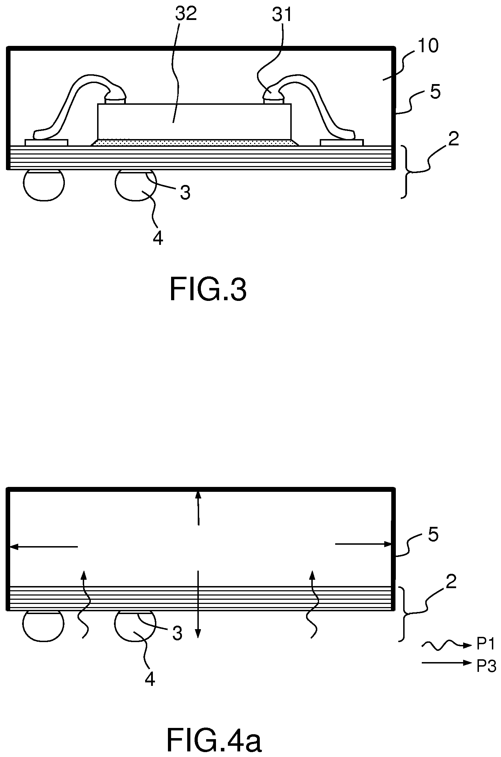

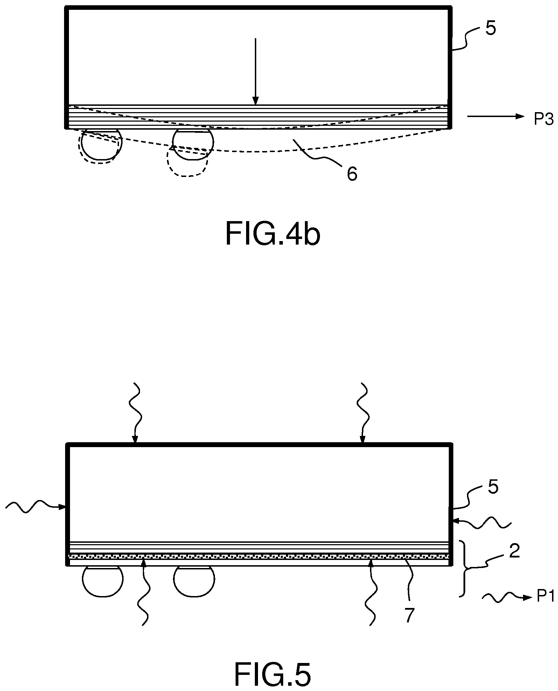

Comme montré sur la figure 3, certains fabricants de boîtiers BGA utilisent un dépôt métallique 5 de blindage sur cinq faces du module électronique. Naturellement la sixième face avec les billes 4 de connexion ne reçoit pas ce dépôt afin de ne pas court-circuiter les billes de connexion. Le boîtier ayant reçu ce type de blindage métallique, donc non-organique est hermétique sur ces cinq faces blindées mais pas sur la sixième ; l'humidité pénètre donc par la sixième face (la face PCB) qui n'est pas protégée comme illustré figure 4a. La diffusion P1 du gaz H₂0 est plus lente grâce au blindage et la pression interne P3 met plus de temps à être atteinte mais les effets de la pénétration de H₂O dans le module sont plus importants au niveau du PCB car la pression P3 s'exerce principalement sur cette sixième face qui présente alors un taux de fuite nettement plus élevé que les cinq autres faces. La figure 4b présente une vue de la déformation possible 6 (en pointillé) de la face PCB avec les billes 4 de connexion.

Une solution pour assurer l'herméticité de boîtiers à billes est de déposer une couche hermétique sur les six faces du boîtier. La protection de la sixième face est beaucoup plus délicate car elle contient la connectique externe : billes, pattes, plots (boîtiers QFN). Cette solution consiste à déposer une couche hermétique sur cette sixième face mais en épargnant les billes lors du dépôt de cette couche isolante. Ceci n'est pas facile pour les raisons suivantes :
A) Il faut un masque ou une opération de décapage local.
B) Dans le cas du masque, il est à craindre que la couche fine non-organique entourant la bille, ne soit pas parfaitement jointe à la bille, surtout après la refusion de celle-ci lors de la brasure. Un espace peut exister et nuire à l'herméticité de l'ensemble.
C) L'équipement pour faire ce dépôt supplémentaire pour rendre le boîtier hermétique, tel qu'une torche à plasma n'est pas utilisé par les fabricants de modules électroniques sur leurs lignes automatiques de blindage en général.

Le but de cette demande de brevet est de palier le problème posé par la non-herméticité de cette sixième face.

On a présenté ce problème en considérant un module électronique comportant un composant électronique reporté sur un PCB, mais bien sûr le problème de l'herméticité est également rencontré pour un module électronique comportant un PCB avec Embedded Die.

La solution consiste à rendre hermétique l'ensemble des six faces du module électronique y compris la face destinée à la connexion externe, en modifiant le PCB. Un dépôt non-organique de protection hermétique est effectué à l'intérieur du PCB multicouche pendant sa fabrication : le niveau « hermétique » est inséré à l'intérieur du multicouche de façon à bloquer la diffusion de l'humidité à l'intérieur du PCB. Ce niveau est de préférence inséré au plus près du niveau connectique externe de façon à protéger le plus grand nombre de couches du PCB contre l'humidité.

La protection des cinq autres faces est faite par :
- dépôt métallique dans le cas d'un blindage électrique, magnétique etc. ou
- dépôt isolant électriquement avec par exemple du SiOx ou tout autre oxyde (Al₂O₃, ...), ou nitrure (Si₃N₄, ...), ou carbure, etc.

Plus précisément l'invention a pour objet un module électronique selon la revendication 1 annexée.

Le (ou les) composant(s) électronique(s) est (sont) par exemple encapsulé(s) sur une face du PCB opposée à la face avec les billes de connexion. Ils peuvent être repartis sur plusieurs niveaux pour former un empilement sur le PCB et pour ainsi obtenir un module électronique 3D.

Le PCB peut lui-même comporter un ou plusieurs composant(s) électronique(s) incorporé(s) au sein du PCB.

Les composants électroniques sont actifs et/ou passifs et/ou des MEMS.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement un exemple de boîtier à billes selon l'état de la technique, vu en coupe,
la figure 2 déjà décrite illustre la pénétration de l'humidité à l'intérieur d'un boîtier vu en coupe, et la pression interne en résultant,
la figure 3 déjà décrite représente schématiquement un exemple de boîtier à billes hermétique sur cinq faces selon l'état de la technique, vu en coupe,
la figure 4a déjà décrite illustre la pénétration de l'humidité à l'intérieur d'un boîtier tel que représenté figure 3, et la pression interne en résultant, la figure 4b illustrant la déformation provoquée par cette pression interne,
la figure 5 représente schématiquement un exemple de boîtier à billes selon l'invention, vu en coupe,
la figure 6 représente schématiquement un zoom sur un exemple de portion de circuit PCB du boîtier à billes de la figure 5,
la figure 7 représente schématiquement un zoom sur un autre exemple de portion de circuit PCB du boîtier à billes de la figure 5,
la figure 8 représente schématiquement un exemple de circuit PCB à composant incorporé selon l'invention, vu en coupe.

D'une figure à l'autre, les mêmes éléments sont repérés par les mêmes références.

Dans la suite de la description, les expressions « supérieur », « inférieur », « avant », « arrière », « côté », sont utilisées en référence à l'orientation des figures décrites. Dans la mesure où le module peut être positionné selon d'autres orientations, la terminologie directionnelle est indiquée à titre d'illustration et n'est pas limitative.

Un circuit PCB est constitué d'un multicouche pouvant avoir de 2 à 40 couches ou niveaux. Pour les modules électroniques avec composants reportés sur un PCB, celui-ci a couramment entre 4 et 8 niveaux ; pour les PCB à composants incorporés (PCB avec « Embedded Die »), le multicouche comporte couramment de 6 à 40 niveaux.

Selon l'invention et comme montré figure 5, un niveau « hermétique » 7 est inséré à l'intérieur du multicouche 2 et de préférence au plus près du niveau connectique externe de façon à bloquer au maximum la diffusion de l'humidité à l'intérieur du PCB. Pour réaliser de manière collective (dans le cadre d'une fabrication collective des modules électroniques hermétiques) ce niveau « hermétique », la couche revêtue du matériau non-organique peut être réalisée de différentes façons :
- Réalisation d'un panneau en résine époxy chargée en silice, de faible épaisseur (entre quelques µm et une centaine de µm), puis dépôt d'un revêtement non organique tel que du SiOx sur une épaisseur comprise entre 0,1 et 1 µm, sur une face du panneau ou sur les 2 faces opposées (de manière à les recouvrir intégralement comme montré sur les figures), vu le faible coût d'un dépôt en plasma atmosphérique lorsque cette technique est choisie ; éventuellement ce panneau ainsi rendu hermétique peut alors être revêtu d'une couche adhésive recto verso surtout lorsqu'il est fin. On obtient ainsi un niveau (ou couche) hermétique inerte.
- Utilisation d'un panneau en résine époxy chargée en silice comportant déjà des éléments conducteurs sur une face ou sur ses deux faces, d'épaisseur typiquement comprise entre 0,1 mm et 0,8 mm et dépôt direct d'une couche de matériau non-organique de SiOx (0,1 à 1 µm) sur une ou deux faces, de manière à les recouvrir intégralement comme montré sur les figures.

On décrit l'utilisation d'un revêtement de SiOx, mais un autre revêtement peut être utilisé tel que tout autre oxyde (Al₂O₃, ...), ou nitrure (Si₃N₄, ...), ou carbure, etc.

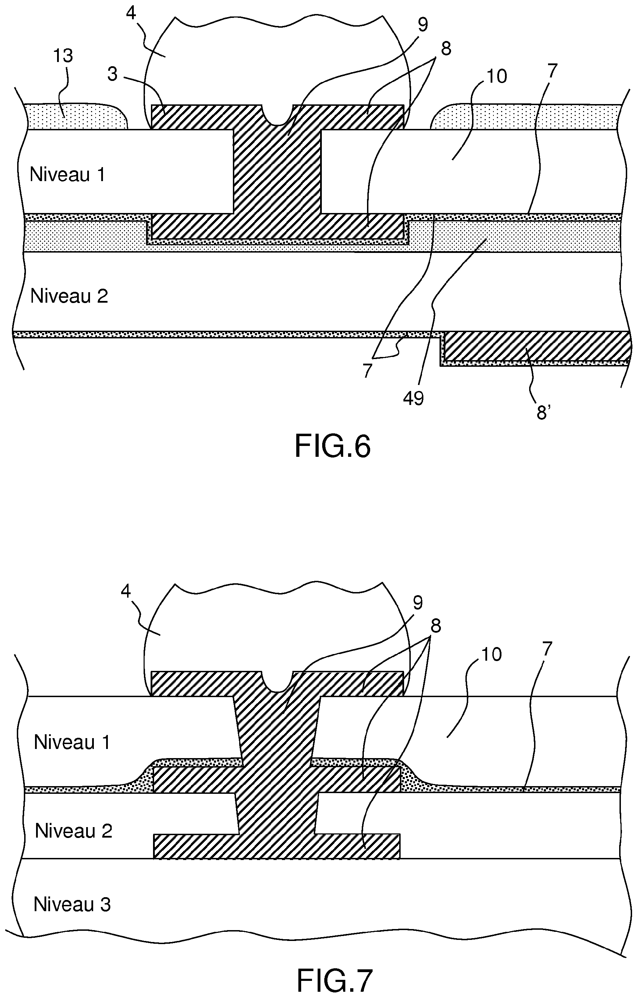

Dans le cas d'un PCB à multicouche, les différentes couches du PCB dont cette couche hermétique 7 peuvent être collées par lamination de manière classique comme montré figure 6, au moyen d'une colle 49. Dans le premier cas (réalisation d'un panneau) cela revient à ajouter au PCB un niveau inerte, alors que dans le second cas (utilisation d'un panneau comportant des éléments conducteurs), on utilise un niveau existant non inerte sur lequel est déposée cette couche hermétique. Cette seconde approche est industriellement intéressante et moins coûteuse. Dans l'exemple de la figure 6, la couche non organique 7 de SiOx est déposée sur toute une face du niveau 1 (qui comporte des conducteurs 3 et 8 sur chacune de ses deux faces) avant le collage du niveau 2 par une colle 49 ; vu le faible coût du dépôt, une couche non organique 7 de SiOx est aussi déposée sur une face du niveau 2 sur laquelle on peut voir une portion de piste électriquement conductrice 8' ; cela permet une double protection à la diffusion du gaz H2O au travers du niveau 2.

Les différentes couches peuvent aussi être formées les unes sur les autres comme montré figure 7 selon un procédé dit « built-up ». Sur chacune des couches (ou niveaux 1, 2, 3) sont formés des éléments électriquement conducteurs tels que des plots 8 ou des pistes comme cela se fait habituellement. Sur l'exemple de la figure 7, les couches sont formées à partir du niveau n, le dernier niveau à être formé étant le niveau 1 qui porte ses plots 3 et ses billes de brasure 4 pour la connectique externe. Ces éléments conducteurs 8, 3 sont formés sur une seule face de chaque couche comme montré sur la figure, la résine 10 de la couche suivante venant mouler ces éléments conducteurs (la résine de la couche 2 vient mouler les éléments conducteurs 8 de la couche 3, la résine de la couche 1 vient mouler les éléments conducteurs 8 de la couche 2). Selon l'invention, un dépôt hermétique 7 est réalisé sur la face du niveau 2 portant des éléments conducteurs 8 avant la formation du niveau 1. Le dépôt non organique 7 est déposé sur toute la surface du niveau 2 et recouvre les plots 8 de ce niveau 2, ce qui rend ce dernier hermétique.

Au fur et à mesure de l'assemblage des couches (par collage ou par formation l'une sur l'autre ou par tout autre procédé), on réalise des via métallisés 9 qui permettent de connecter certains éléments électriquement conducteurs 8, 3 à travers la partie diélectrique organique 10 d'un niveau avec ceux d'un autre niveau comme on peut le voir figure 6, voire de plusieurs niveaux comme montré dans l'exemple de la figure 7. Le via traverse la partie diélectrique organique 10 d'un niveau et s'arrête sur le plot 8 ou la piste du niveau à atteindre.

Certains de ces niveaux situés au milieu du multicouche et désignés « core PCB » peuvent contenir des plans conducteurs d'alimentation.

On distingue deux techniques de réalisation de ces via selon qu'ils sont gravés au moyen d'un faisceau laser ou percés mécaniquement au moyen par exemple de forets diamantés. Les via gravés par faisceau laser sont généralement légèrement coniques comme illustré figure 7 alors qu'ils sont cylindriques lorsque percés par un foret mécanique comme illustré figure 6.

Le fin revêtement non organique 7 peut être localement détruit lors de la réalisation d'un via comme montré figure 7. L'herméticité n'est pas remise en cause puisque le métal des via 9 est hermétique.

Après cette étape de réalisation des via, leur métallisation chimique et électrochimique est effectuée comme habituellement.

Des composants électroniques sont collés et câblés à un PCB à niveau hermétique tel que précédemment décrit, puis moulés dans de la résine. Les composants électroniques encapsulés peuvent être répartis sur plusieurs niveaux pour former un empilement sur le PCB et pour ainsi obtenir un module électronique 3D.

Cet ensemble est alors découpé verticalement (= selon Z) pour former des boîtiers BGA unitaires. Les étapes décrites jusqu'à présent ont avantageusement été réalisées de manière collective. De manière classique, des pistes d'interconnexion électrique sont formées sur les faces verticales de ces boîtiers : on obtient ainsi des modules électroniques.

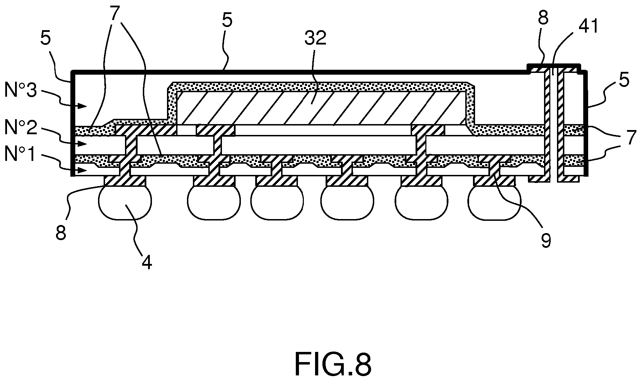

Dans le cas de composants électroniques incorporés dans le PCB, celui-ci est découpé verticalement pour former des modules électroniques. On montre figure 8 un exemple de PCB à composant 32 incorporé. Il comporte 3 couches (n°1, n°2, n°3) dont la 2ième sur laquelle est placé un composant 32. Deux couches de revêtement non organique 7 sont formées, l'une entre les couches 1 et 2, l'autre sur la couche avec le composant. Des trous 41 métallisés sont formés qui traversent le PCB sur toute son épaisseur.

Un module électronique peut cumuler les deux cas précédents c'est-à-dire qu'il comporte un PCB à niveau hermétique et à composant(s) incorporé(s) et un ou plusieurs composants collés, câblés et moulés placés sur la face opposée à la face de connectique externe.

Une couche hermétique de revêtement non organique conducteur 5 ou électriquement isolant est déposée sur les quatre faces verticales et la face supérieure (c'est-à-dire sans les billes de brasure) de chaque module pour ainsi obtenir un module électronique hermétique. Comme on peut le voir sur les figures 5 et 8, cette couche hermétique recouvre intégralement ces cinq faces ; il n'y a pas de rupture d'herméticité entre ces cinq faces. Ceci est illustré figure 5 pour un boîtier à billes qui ne reçoit plus d'humidité par diffusion P1 et figure 8 pour un PCB à composant intégré. On est ainsi assuré de l'herméticité des cinq faces. Le module est également protégé de la diffusion de l'humidité qui ne peut provenir que de la sixième face à partir du niveau hermétique inséré dans le PCB.

## Revendications

1. Module électronique comportant un circuit PCB multicouche (2) et un ou plusieurs composants électroniques (32) électriquement connectés audit circuit PCB multicouche (2) qui comprend sur une face des billes (4) de connexion électrique externe du module électronique, le circuit PCB comprenant une couche interne non organique (7) électriquement isolante de protection hermétique, **caractérisé en ce que** le module comprend six faces avec une couche non organique de protection hermétique électriquement isolante ou conductrice (5) couvrant intégralement les cinq faces autres que celle formée par le circuit PCB et **en ce que** la couche interne non organique (7) électriquement isolante de protection hermétique est en contact direct avec la couche non organique de protection hermétique électriquement isolante ou conductrice (5), de sorte à former un joint hermétique autour des un ou plusieurs composants électroniques (32).

2. Module électronique selon la revendication précédente, **caractérisé en ce que** les un ou plusieurs composants électroniques (32) sont encapsulés sur une face du circuit PCB (2) opposée à la face avec les billes de connexion.

3. Module électronique selon la revendication précédente, **caractérisé en ce que** les composants électroniques (32) encapsulés sont répartis sur plusieurs niveaux pour former un empilement sur le circuit PCB et pour ainsi obtenir un module électronique 3D.

4. Module électronique selon l'une des revendications précédentes, **caractérisé en ce que** le circuit PCB comporte un ou plusieurs des composants électroniques (32) incorporés au sein du circuit PCB.

5. Module électronique selon l'une des revendications précédentes, **caractérisé en ce que** le circuit PCB comprend une autre couche interne non organique (7) électriquement isolante de protection hermétique.

6. Module électronique selon l'une des revendications précédentes, **caractérisé en ce que** les composants électroniques (32) sont des composants actifs et /ou des composants passifs et/ou des MEMS.

## Patentansprüche

1. Elektronisches Modul, aufweisend eine mehrschichtige Leiterplattenschaltung (2) und eine oder mehrere elektronische Komponenten (32), die mit der mehrschichtigen Leiterplattenschaltung (2) elektrisch verbunden sind, die auf einer Seite Kugeln (4) für die externe elektrische Verbindung des elektronischen Moduls umfasst, wobei die Leiterplattenschaltung eine elektrisch isolierende, nicht organische interne hermetische Schutzschicht (7) umfasst, **dadurch gekennzeichnet, dass** das Modul sechs Seiten umfasst, wobei eine elektrisch isolierende oder leitfähige, nicht organische hermetische Schutzschicht (5) die fünf Seiten vollständig bedeckt, die von derjenigen verschieden sind, die durch die Leiterplattenschaltung gebildet ist, und dadurch, dass die elektrisch isolierende, nicht organische interne hermetische Schutzschicht (7) derart mit der elektrisch isolierenden oder leitfähigen, nicht organischen hermetischen Schutzschicht (5) in direktem Kontakt steht, dass eine hermetische Abdichtung um das eine oder die mehreren elektronischen Bauteile (32) gebildet wird.

2. Elektronisches Modul nach dem vorhergehenden Anspruch, **dadurch gekennzeichnet, dass** das eine oder die mehreren elektronischen Bauteile (32) auf einer Seite der Leiterplattenschaltung (2) eingekapselt sind, die zu der Seite mit den Verbindungskugeln entgegengesetzt ist.

3. Elektronisches Modul nach dem vorhergehenden Anspruch, **dadurch gekennzeichnet, dass** die eingekapselten elektronischen Bauteile (32) auf mehreren Ebenen verteilt sind, um einen Stapel auf der Leiterplattenschaltung zu bilden und um so ein elektronisches 3D-Modul zu erhalten.

4. Elektronisches Modul nach einem der vorhergehenden Ansprüche, **dadurch gekennzeichnet, dass** die Leiterplattenschaltung ein oder mehrere elektronische Bauteile (32) aufweist, die innerhalb der Leiterplattenschaltung inkorporiert sind.

5. Elektronisches Modul nach einem der vorhergehenden Ansprüche, **dadurch gekennzeichnet, dass** die Leiterplattenschaltung eine weitere elektrisch isolierende, nicht organische, interne hermetische Schutzschicht (7) umfasst.

6. Elektronisches Modul nach einem der vorhergehenden Ansprüche, **dadurch gekennzeichnet, dass** die elektronischen Bauteile (32) aktive Bauteile und/oder passive Bauteile und/oder MEMS sind.

## Claims

1. An electronic module containing a multilayer PCB circuit (2) and one or more electronic components (32) that are electrically connected to said multilayer PCB circuit (2) that comprises, on one face, electrical connection balls (4) for the external electrical connection of the electronic module, the PCB circuit comprising a hermetically protective electrically insulating inorganic inner layer (7), **characterised in that** the module comprises six faces with an electrically insulating or conductive inorganic hermetic protection layer (5) entirely covering the five faces other than that formed by the PCB circuit and **in that** the hermetically protective electrically insulating inorganic inner layer (7) is in direct contact with the electrically insulating or conductive inorganic hermetic protection layer (5), so as to form a hermetic seal around the one or more electronic components (32).

2. The electronic module according to the preceding claim, **characterised in that** the one or more electronic components (32) are encapsulated on one face of the PCB circuit (2) opposite the face with the connection balls.

3. The electronic module according to the preceding claim, **characterised in that** the encapsulated electronic components (32) are distributed over multiple levels to form a stack on the PCB circuit and to thus obtain a 3D electronic module.

4. The electronic module according to one of the preceding claims, **characterised in that** the PCB circuit contains one or more of the electronic components (32) that are incorporated within the PCB circuit.

5. The electronic module according to one of the preceding claims, **characterised in that** the PCB circuit comprises another hermetically protective electrically insulating inorganic inner layer (7).

6. The electronic module according to one of the preceding claims, **characterised in that** the electronic components (32) are active components and/or passive components and/or MEMS.
